# EUROPEAN PATENT APPLICATION

(11) **EP 4 575 320 A1**
(43) Date of publication of application: **25.06.2025**
(21) Application number: 24217638.6
(22) Date of filing: 05.12.2024
(51) Int. Cl.: F24C 7/08, A47L 15/42, D06F 39/14, F24C 15/02, F25D 23/02, H03K 17/96

(54) **HOUSEHOLD APPLIANCE COMPRISING A DOOR HANDLE**

(30) Priority: 19.12.2023 SI 202300162
(71) Applicant: Gorenje d.o.o., 3320 Velenje (SI)
(72) Inventor: LAJMIS, Florjan, 1241 Kamnik (SI); FUNTEK, Jure, 3327 Smartno ob Paki (SI)
(74) Representative: Ivancic, Bojan

(57) **Abstract**

A household appliance according to the invention comprises a first electrode (10), which is electrically insulated from any electrically conductive material and arranged in the area above the door aperture, which can be closed by means of a door (4), and a second electrode (12), which is arranged on the side of the said door (4) and spaced from the said first electrode (10). The said electrodes (10, 12) are electrically insulated from each other. Arranged inside a housing (2), in the area above the door aperture, which can be closed by means of the door (4), is an electronic module (7), which comprises an electronic circuit (8) and a controller (9) with integrated software that facilitates capacity measurements, which makes it possible to sense the touch of a user (6). The said handle (5), by means of which it is possible to handle the door (4), is provided as an interface for sensing the touch of the user (6).

## Description

The present invention relates to a household appliance comprising a door handle arranged on the outside of the door of the household appliance, by means of which it is possible to close the interior of the household appliance in relation to the surroundings of the said household appliance, wherein the said door handle comprises at least a part of an electronic system for cooperation between the household appliance and its user.

The household appliance referred to above is, for example, disclosed in patent applications WO2020046150A1, EP3034948A1, WO2020046151A1. The said known solutions mainly relate to the integration of an electronic touch sensing module on/inside the door handle of the household appliance or inside its door, which significantly limits the design of the handle or door of the said appliance. Moreover, the said known solutions require an electrical connection between the door of the household appliance and a control unit of the said appliance, which cooperates with the said electronic module either via dedicated hinges or electric conductors. The specified characteristics present significant shortcomings that consequently limit the design and usefulness of the household appliance, prevent simple upgrades of existing appliances and complicate the assembly of the final household appliance. The above characteristics also result in higher costs of manufacturing the appliance.

The object of the present invention is to create a household appliance of the type referred to above, which would remedy the shortcomings of known solutions.

The object according to the present invention is accomplished by the characteristics set forth in the characterising portion of claim 1. Details of the invention are disclosed in the corresponding sub-claims.

The present invention relates to a household appliance comprising a door handle, which is arranged on the outside of a household appliance door, by means of which it is possible to close the interior of the household appliance in relation to the surroundings of the said household appliance, wherein the said door handle comprises at least an electronic system for cooperation between the household appliance and the user of the handle of the household appliance or to enable the sensing of touch commands of the user. Touch sensing is based on a technology that measures the capacity between the handle of the appliance and/or any other electrically conductive surface on the appliance and the electric potential of earth.

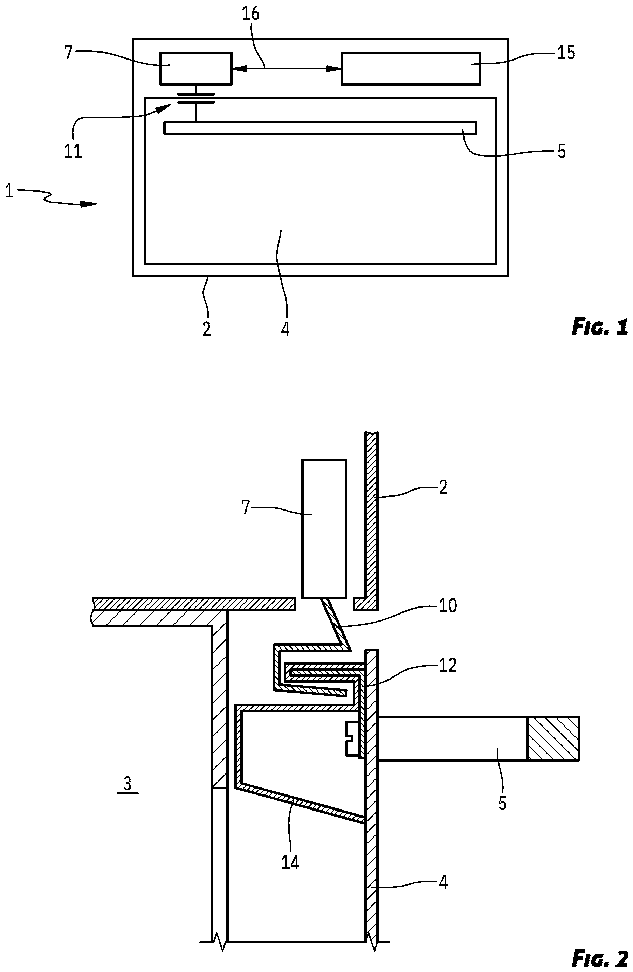

The invention is further described in detail by way of a non-limiting embodiment and with a reference to the accompanying drawings where
- Fig. 1: shows a household appliance in a schematic view from the front,
- Fig. 2: shows a detail of the household appliance from Fig. 1 in a cross-section from the side,

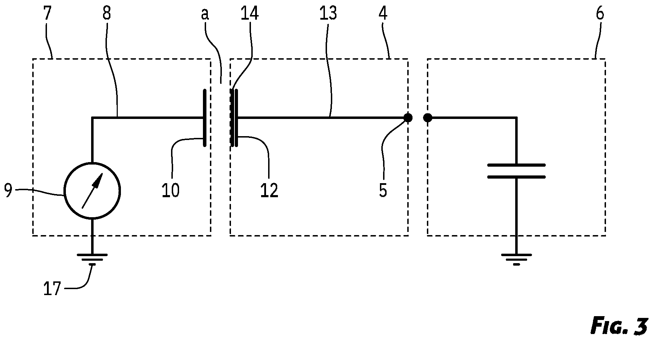

- Fig. 3: shows an interaction between the household appliance and a user in a schematic view,
- Fig. 4: shows a signal time line upon a one-time user interaction with the household appliance in a schematic view,
- Fig. 5: shows a signal time line upon a repeated user interaction with the household appliance in a schematic view, and
- Fig. 6: shows a detection of the extent to which a door of the household appliance is open or closed in a schematic view.

A household appliance 1, such as an oven, refrigerator, dish washer, washing machine, or similar, comprises a housing 2 with at least one compartment 3 for receiving the item to be heat-treated, stored, or similar, wherein at least one said compartment 3 can be closed by means of a single-section or multi-section door 4, which is fixed to the housing 2 of the household appliance 1 by means of hinges, preferably in a way that the said door 4 is easily removable. The said door 4 can be opened or closed by means of a handle 5, which is connected to the door 4.

The said handle 5 of the door 4 of the household appliance 1 is at least partly made of an electrically conductive material, such as metal. The said handle 5, by means of which it is possible to handle the door 4 of the household appliance 1, is, according to the present invention, also provided as an interface for sensing the touch of a user 6, wherein the said handle 5 must be electrically insulated from other electrically conductive elements of the door 4 of the household appliance 1 and the housing 2 of the household appliance 1.

Furthermore, according to the present invention, it is provided that arranged inside the housing 2 of the household appliance 1, in the area above the door aperture, which can be closed by means of the door 4, is an electronic module 7. The latter is preferably arranged in the area directly above the said door aperture, which can be closed by means of the door 4. Furthermore, the said electronic module 7 comprises an electronic circuit 8, a controller 9 with integrated software that facilitates capacity measurements" which make it possible to sense the touch of the user6, and a first electrode 10. The electronic module 7 is arranged in such a way that the first electrode 10 is electrically insulated from the housing 2 of the household appliance 1 or any electrically conductive material.

A capacitive coupler 11 comprises the first electrode 10, which is connected to the electronic module 7 and arranged in the area above the door aperture, which can be closed by means of the door 4, and a second electrode 12, which is arranged on the side of the said door 4 and spaced from the said first electrode 10. The said electrodes 10, 12 are electrically insulated from each other, for instance by means of an air gap a. The said capacitive coupler 11 facilitates indirect measurement of capacity between the handle 5 of the door 4 of the household appliance 1 and the electric potential of the earth in such a way that the first electrode 10 of the electronic module 7 is galvanically isolated from the handle 5 of the household appliance 1, while the second electrode 12 is, by means of a conductor 13, galvanically connected to the handle 5 of the household appliance 1, which can be touched by the user 6.

The said first electrode 10 is formed in such a way that it allows for the compensation of mechanical deviations and structural strain in the manufacture, assembly, and use of the household appliance 1 according to the invention, wherein it is, for example, formed from a flexible material in the manner of a spring.

The said second electrode 12, which is arranged on the side of the said door 4 of the household appliance 1, is arranged on the upper rear side of the door 4 in such a way that it is aligned with the opposite first electrode 10 whenever the door 4 of the household appliance 1 is in a position that closes the said compartment 3. The said second electrode 12 is electrically connected to the handle 5 of the door 4 of the household appliance 1 by means of electric conductors or other electrically conductive parts. At least one of the said electrodes 10, 12 is electrically insulated from any other electrically conductive part of the household appliance 1. In the presented embodiment, the said second electrode 12 is, by means of an insulating element 14, electrically insulated from any other electrically conductive part of the household appliance 1. In the presented embodiment, it is provided that the electrode 12 is inserted into a plastic flange on the door 4 of the household appliance 1 by means of a technology for injecting metal parts into plastics. Furthermore, in the preferred embodiment, it is provided that the overlap area of electrodes 10, 12 is as large as possible, which improves the quality of the capacity contact and consequently improves the sensitivity of the entire touch sensing system on the handle of the door 4 of the household appliance 1.

To operate the household appliance 1 according to the invention, a user interface 15 with a screen and suitable markings is further provided. The said user interface 15 and the said electronic module 7 are connected to each other by means of an electronic communication interface 16, such as UART, I2C, LIN, SPI, a discrete electric signal, etc.

By means of the capacitive coupler 11, it is possible to measure the capacity on the handle 5 of the household appliance 1 with a minimal intervention into the design of the door 4 of the household appliance 1, which eliminates the need for installing the electronic module 7 in the handle 5 of the household appliance 1 or the door 4. There is also no need for installing electric conductors between the door 4 of the household appliance 1 and the housing 2 of the household appliance 1, allowing for a simple integration of the touch sensing system on the handle 4 of the household appliance 1 when it comes to existing household appliances.

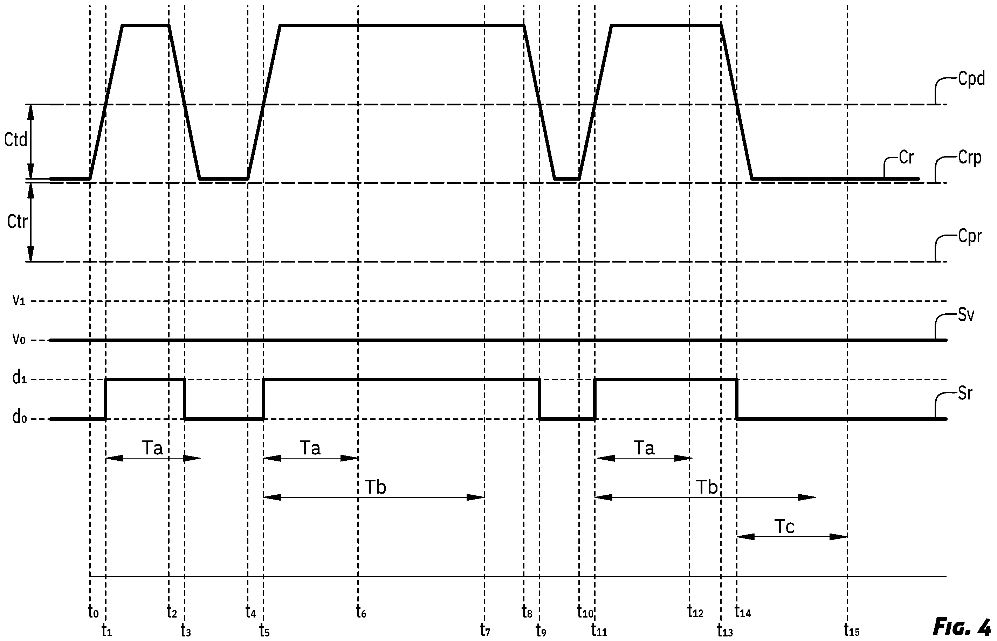

Fig. 4 shows a time line of signals for the recognition of patterns of one-time user touch interactions with the handle 5 of the door 4. The software of the electronic module 7, which is not the subject of the present invention, uses a comparison between the measured capacity value Cᵣ and the threshold capacity value C_{pd} to sense the touch of the handle 5 of the door 4 provided that the door 4 is closed, wherein the signal Sᵥ of the door 4 which takes the value V₀, sets the value of the signal Sᵣ of the handle 5, which serves as the basis for recognising known touch patterns.

The capacity value
C_{pd} constitutes the sum of the long-term average capacity value Cᵣₚ and constant C_{td},
Cₚᵣ p constitutes the sum of the long-term average capacity value Cᵣₚ and constant Cₜᵣ.
C_{td}, Cₜᵣ present constants that are subject to the embodiment and determined in advance,
and they can optionally be determined or adjusted in real time by means of advanced machine learning algorithms.

The time interval values Ta, Tb, and Tc are determined in advance and adjusted to the desired user experience with the household appliance. The indicative values of the said time intervals amount to Ta = 50 ms, Tb = 320 ms, Tc = 320 ms.

The electronic module 7 of the household appliance 1 according to the invention performs three basic tasks:
a) Performing periodic measurements, i.e. sampling capacity Cᵣ values between the handle 5 of the door 4 and the electric potential 17 of the earth, wherein the said capacity Cᵣ is preferably measured in a way that the time between two consecutive measurements or the time of sampling is constant and as short as possible, allowing for quick responsiveness and the possibility of additional software processing of the signal, such as a low-pass filter, a median filter, value averaging, etc.;
b) Converting the measured capacity Cᵣ values of the handle 5 into the signal Sᵣ of status of the user's touch on the door handle and signal Sᵥ of the door status, wherein the software of the electronic module 7 performs a calculation of the long-term average value of the measured capacity Cᵣₚ of the handle 5 of the household appliance 1 in the event when no touch of the user is present; the calculation is performed after each capacity measurement, when the difference between the current capacity value Cᵣ and long-term average capacity value Cᵣₚ is also calculated; if the said difference is greater than the value of constant C_{td}, the value of the signal Sᵣ of touch status is set to value d₁, otherwise, the value of the signal is set to value d₀; based on the measured capacity value Cᵣ, the status of the door (open or closed) is also determined and used in further signal processing;
c) Recognising known touch patterns, wherein the software of the electronic module 7, after each conversion of the measured capacity value Cᵣ of the handle 5 of the door 4 of the household appliance 1, checks whether the conditions meet any of the touch patterns determined in advance; The said check of condition adequacy is preferably based on the measurement of time between temporally consecutive changes in signal Sᵣ of the status of touching the handle of the door, for instance the sensing of a one-time touch, wherein the sensing of certain touch patterns on the handle 5 of the door 4 of the household appliance 1 can also take into account the calculated value of the difference between the measured capacity value Cᵣ and long-term average capacity value Cᵣₚ; whenever a valid touch pattern is sensed, the information about the type of touch pattern is transmitted via the electronic communication interface 16 to the user interface 15 of the household appliance 1, wherein it is also enabled to sense the extent to which door 4 of the household appliance 1 is opened or closed and transmit this information via the electronic communication interface 16 to the user interface 15 of the household appliance 1.

Described in continuation by referring to Fig. 4 is one of the possible embodiments of the flow of sensing a one-time touch of the handle 5 of the door 4 on the household appliance 1 according to the invention by the user.

Initially, at time t₀, the user touches the handle 5 of the door 4 of the household appliance 1, which reflects in an increase of the measured capacity value Cᵣ. At time t₁ the user is still touching the handle 5 of the door 4, wherein the said capacity value Cᵣ rises above the level for touch sensing on the handle 5 of the door 4 C_{pd}. The said software sets the signal Sᵣ of the handle 5 to level d₁ (touch) and starts the time measurement of touch duration. At time t₂, the user stops touching the handle 5 of the door 4, wherein at time t₃, the measured capacity value Cᵣ drops below the level of the capacity value C_{pd} for touch sensing. As the measured time of touch duration is shorter than the shortest allowed time interval Ta of touch duration, which results in failure to meet the first condition for touch pattern recognition, the said software cancels the current touch pattern sensing process and sets the signal Sᵣ of the handle 5 to level d₀ (no touch), after which the household appliance 1 is ready to recognise new touch patterns.

At time t₄, the user again touches the handle 5 of the door 4 of the household appliance 1, which is reflected in an increase of the measured capacity value Cᵣ. At time t₅, the user is still touching the handle 5 of the door 4, wherein the measured capacity value Cᵣ rises above the capacity level C_{pd} for touch sensing on the handle 5 of the door 4. The said software sets the signal Sᵣ of the handle 5 to level d₁ (touch) and starts the time measurement of touch duration. At time t₆, the user is still touching the handle 5 of the door 4, wherein the measured time value of touch duration is greater than the shortest allowed time interval Ta of touch duration, which meets the first condition for touch pattern recognition. At time t₇, the user is still touching the handle 5 of the door 4, wherein the said software detects that the measured time value of touch duration is greater than the longest permitted time interval Tb of touch duration. As the second condition for touch pattern sensing is not met, the integrated software cancels the current touch pattern recognition process.

At time t₈, the user stops touching the handle 5 of the door 4 of the household appliance 1. At time t₉, the measured capacity value Cᵣ drops below the value level for touch sensing capacity C_{pd}. The said software sets the signal Sᵣ of the handle to level d₀ (no touch), after which the household appliance 1 is ready to recognise new touch patterns.

At time t₁₀, the user again touches the handle 5 of the door 4 of the household appliance, which is reflected in an increase in the measured capacity value Cᵣ. As the user is still touching the handle 5 of the door 4, the capacity value Cᵣ measured at time t₁₁ rises above the capacity level C_{pd} for touch sensing on the handle 5 of the door 4. The said software sets the signal Sᵣ of the handle to level d₁ (touch) and starts the time measurement of touch duration. At time t₁₂, the user is still touching the handle 5 of the door 4, wherein the measured value of touch duration is greater than the shortest time allowed Ta of touch duration, which meets the first condition for touch pattern recognition.

At time t₁₃, the user stops touching the handle 5 of the door 4 of the household appliance 1. The measured capacity value Cᵣ at time t₁₄ drops below the value level for touch sensing capacity C_{pd}. The measured time value of touch duration is less than the longest allowed time interval Tb of touch duration, which also meets the second condition for touch pattern recognition. The said software sets the signal Sᵣ of the handle to level d₀ (no touch) and starts the measurement of the time interval Tc of response delay, within which it will wait for a potential repeated touch on the handle 5 of the door 4.

At time t₁₅, the integrated software detects that the response delay time has timed out. As no repeated touch was sensed on the handle 5 of the door 4 during the response delay time, the last condition for touch pattern recognition is met. The said software of the electronic module 7 communicates the information about the recognition of a one-time touch via the communication interface 16to the user interface 15 of the household appliance 1, wherein the latter is ready to recognise new touch patterns.

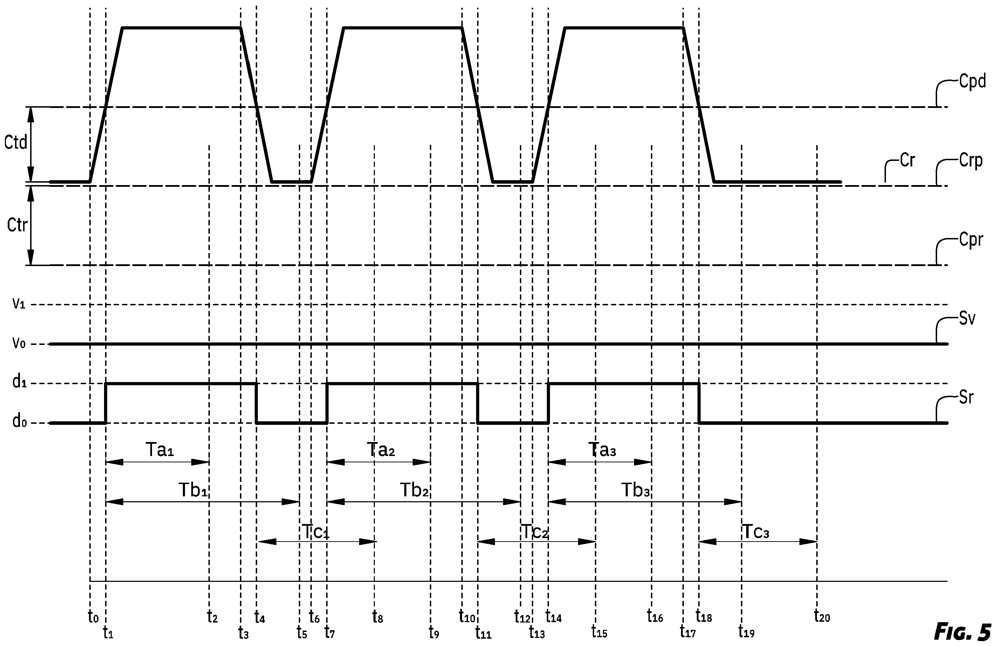

Furthermore, described in continuation by referring to Fig. 5 is one of the possible embodiments of the flow of sensing a repeated touch of the handle 5 of the door 4 of the household appliance 1 according to the invention by the user. By comparing the measured capacity value Cᵣto the threshold capacity value C_{pd} for touch sensing on the handle 5 of the door 4 and under the condition that the door 4 is closed and signal Sᵥ of the door has the value V₀, the said software of the electronic module 7 sets the value of signal Sᵣ of the handle, which serves as the basis for recognising known touch patterns.

The capacity value
C_{pd} constitutes the sum of the long-term average capacity value Cᵣₚ and constant C_{td},
Cₚᵣ p constitutes the sum of the long-term average capacity value Cᵣₚ and constant Cₜᵣ.
C_{td}, Cₜᵣ present constants that are subject to the embodiment and determined in advance,
and they can optionally be determined or adjusted in real time by means of advanced machine learning algorithms.

The time interval values Ta₁...Taₙ, Tb₁...Tbₙ and Tc₁...Tcₙ are normally determined in the system development phase and adjusted based on the desired user experience with the household appliance. With one of the possible embodiments of the household appliance 1, used, for example, are indicative values Ta₁ = Ta₂ = Ta₃ = 50 ms, Tb₁ = Tb₂ = Tb₃ = 320 ms, Tc₁ = Tc₂ = Tc₃ = 320 ms.

Initially, at time t₀, the user touches the handle 5 of the door 4 of the household appliance 1, which results in an increased measured capacity value Cᵣ. At time t₁, the user is still touching the handle 5 of the door 4, wherein the measured capacity value Cᵣ rises above the capacity value C_{pd}, which determines touch sensing on the handle 5 of the door 4. The said software sets the signal Sᵣ of the handle to level d₁ (touch) and starts the time measurement of touch duration. At time t₂, the user is still touching the handle 5 of the door 4, wherein the measured time value of touch duration is greater than the shortest allowed time interval Ta₁ of touch, which meets the first condition for touch pattern recognition.

At time t₃, the user stops touching the handle 5 of the door 4 of the household appliance 1 and, as a result, at time t₄, the measured capacity value Cᵣ drops below the value level of capacity C_{pd}. The measured time value of touch duration is less than the longest allowed time interval Tb₁ of touch duration, which also meets the second condition for touch pattern recognition. The said software sets the signal Sᵣ of the handle to value d₀ (no touch) and starts the measurement of the time interval Tc₁ of response delay, within which it will wait for a potential repeated touch on the handle 5 of the door4. If until the timeout of the time interval Tc₁ of response delay no repeated touch occurs, then at time t₈, the said software transmits information about the recognition of a one-time touch via the communication interface 16 to the user interface 15, which the user uses to operate the household appliance 1. Thus, the system is ready to recognise new touch patterns.

At time t₆, the user again touches the handle 5 of the door 4, which results in an increased measured capacity value Cᵣ. At time t₇, the user is still touching the handle 5 of the door 4, wherein the measured capacity value Cᵣ rises above the capacity value C_{pd} for touch sensing on the handle 5 of the door 4. The said software sets the signal Sᵣ of the handle to value d₁ (touch) and starts the time measurement of touch duration. As at time t₉ the user is still touching the handle 5 of the door 4, the measured value of the time interval of touch duration is greater than the shortest allowed time interval Ta₂ of touch duration, which meets the next condition for touch pattern recognition.

At time t₁₀, the user stops touching the handle 5 of the door 4, wherein at time t₁₁, the measured capacity value Cᵣ drops below the capacity value C_{pd} for touch sensing on the handle 5 of the door 4. The measured value of the time interval of touch duration is less than the longest allowed time interval Tb₂ of touch duration, which meets the next condition for touch pattern recognition. The said software sets the signal Sᵣ of the handle to value d₀ (no touch) and starts the measurement of the time interval Tc₂ of response delay, within which it will wait for a potential repeated touch on the handle 5 of the door 4. If until the timeout of the time interval Tc₂ of response delay no repeated touch occurs, then at time t₁₅ the said software transmits via the communication interface 16 information about the recognition of a two-time touch on the module 7 for operating the household appliance 1. Thus, the system is ready to recognise new touch patterns.

At time t₁₃, the user again touches the handle 5 of the door 4 of the household appliance 1, which is reflected in an increased measured capacity value Cᵣ. As at time t₁₄, the user is still touching the handle 5 of the door 4, the measured capacity value Cᵣ rises above the capacity value C_{pd} for touch recognition on the handle 5 of the door 4. The said software sets the signal Sᵣ of the handle to value d₁ (touch) and starts the measurement of the time interval of touch duration.

As at time t₁₆, the user is still touching the handle 5 of the door 4, the measured time interval value of touch duration is greater than the shortest allowed time interval Ta₃ of touch duration, which meets the next condition for touch pattern recognition.

At time t₁₇, the user stops touching the handle 5 of the door 4, wherein at time t₁₈, the measured capacity value Cᵣ drops below the capacity value C_{pd} for touch sensing. The measured time interval value of touch duration is less than the longest allowed time interval Tb₃ of touch duration, which meets the next condition for touch pattern recognition. The said software sets the signal Sᵣ of the handle to value d₀ (no touch) and starts the measurement of the time interval Tc₃ of response delay, within which it will wait for a potential repeated touch on the handle 5 of the door 4.

At time t₂₀, the said software detects that the time interval Tc₃ of response delay has timed out. As no repeated touch was sensed on the handle 5 of the door 4 during the time interval Tc₃ of response delay, the last condition for repeated touch pattern recognition is met. via the communication interface 16, the said software transmits information about the recognition of a repeated touch to the user interface 15, which the user uses to operate the household appliance 1. The system is ready to recognise new touch patterns.

The described algorithm for touch pattern recognition allows for the recognition of various combinations of consecutive touch counts and touch durations.

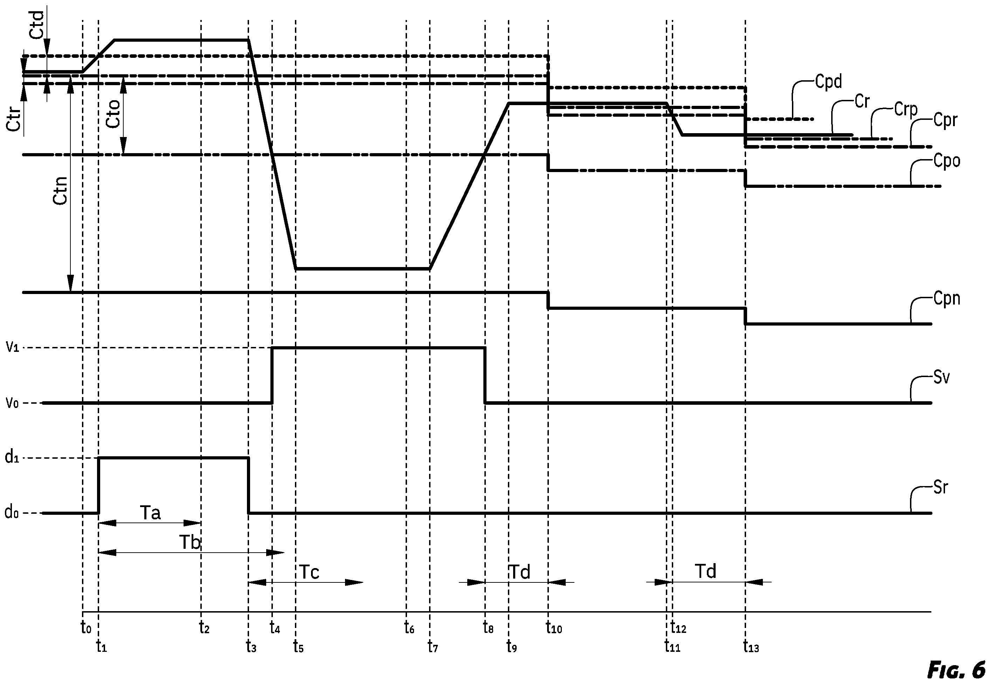

Shown in continuation by means of Fig. 6 is a time line of signals in the event that the user opens and closes the door 4 of the household appliance 1. The said software of the electronic module 7 determines the status of door openness by means of comparing the measured capacity value Cᵣ to the threshold capacity value Cₚₒ to detect the extent to which the door 4 is open and the threshold capacity value Cₚₙ to detect the adequacy of system operation.

The capacity value
Cₚₒ constitutes the sum of the long-term average capacity value Cᵣₚ and constant Cₜₒ,
Cₚₙ constitutes the sum of the long-term average capacity value Cᵣₚ and constant Cₜₙ,
Cₜₒ, Cₜₙ present constants that are subject to the embodiment and determined in advance and they can optionally be determined or adjusted in real time by means of advanced machine learning algorithms.

At time t₀, the user holds the handle 5 of the door 4 of the household appliance 1, which is reflected in an increased measured capacity value Cᵣ. As a result, at time t₁, the measured capacity value Cᵣ rises above the capacity value C_{pd} for touch sensing on the handle 5. The said software sets the signal Sᵣ from the handle to value d₁ (touch) and starts the time measurement of touch duration.

As at time t₂, the user is still holding the handle 5 of the door 4, but has not yet started opening the door 4, the measured time value of touch duration is greater than the shortest allowed time interval of touch duration Tₐ, which meets the first condition for touch pattern recognition.

At time t₃, the user starts opening the door 4, wherein the electrodes 10, 12 of the capacitive coupler 11 start moving apart from each other, which results in a drop in the measured capacity value Cᵣ. As the latter drops below the said capacity value C_{pd}, the said software sets the signal Sᵣ of the handle 5 to value d₀ (no touch) and starts the measurement of the time interval Tc of response delay.

When the user continues to open the door 4, at time t₄, the measured capacity value Cᵣ drops additionally and reaches the capacity value Cₚₒ of the threshold for detecting the extent to which the door is open. The said software sets the signal Sᵥ of the door to value V₁ (open) and stops the implementation of the touch pattern recognition algorithm. From this moment on, the system does not allow for touch sensing on the handle 5 of the door 4.

At time t₅, the door 4 is open to a degree where further opening does not cause a drop in the measured value of capacity Cᵣ as the electrodes 10, 12 of the capacitive coupler 11 are fully spaced apart.

At time t₆, the user starts closing the door 4, wherein the electrodes 10, 12 of the capacitive coupler 11 are fully spaced apart from each other. The measured capacity value Cᵣ remains constant until the door 4 closes to a degree where the electrodes 10, 12 of the capacity coupler 11 come close to each other.

At time t₇, the user closes the door 4 to a degree where the measured capacity value Cᵣ starts increasing, which is the result of an increasing surface area of overlap between the electrodes 10, 12 of the capacitive coupler 11.

As the user continues to close the door 4, at time t₈, they close it to a degree where the measured capacity value Cᵣ exceeds the capacity value Cₚₒ of the threshold for sensing the extent to which the door 4 is open. The said software sets the signal Sᵥ of the door to value V₀ (closed) and starts the measurement of the time interval Td of system calibration delay.

At time t₉, the door 4 stops at a final, closed position, wherein the measured capacity value Cᵣ stabilises at a value that is normally unequal to the long-term average capacity value Cᵣp, calculated before starting to open the door 4.

At time t₁₀, the said software detects that the time of system calibration delay has timed out and starts the system calibration process, which sets the value of the long-term average capacity value Cᵣₚ to the measured current capacity value Cᵣ, and simultaneously recalculates the capacity values C_{pd}, Cₚᵣ, Cₚₒ and Cₚₙ. If at this moment, the user is not touching the handle of the door 4 of the household appliance 1, the system is ready for touch sensing on the handle 5 of the door 4. In the opposite case, the system remains unresponsive to touch sensing until the user stops touching the handle 5 of the door 4.

At time t₁₁, when the user stops contact with the handle 5 of the door 4, the measured capacity value Cᵣ drops. At time t₁₂, the measured capacity value Cᵣ drops below the capacity value Cₚᵣ for initiating system recalibration, wherein the said software starts measuring the time interval Td of delayed system calibration.

At time t₁₃, the said software detects that the time for delayed system calibration has timed out and initiates the calibration process, which sets the value of the long-term average capacity value Cᵣₚ to the measured current capacity value Cᵣ. Simultaneously, it recalculates new capacity values C_{pd}, Cₚᵣ, Cₚₒ and Cₚₙ. The system is ready for touch sensing on the handle 5 of the door 4 of the household appliance1.

## Claims

1. A household appliance comprising a handle of a door, wherein the door is arranged on a housing and the handle is arranged on the outside of the door, wherein it is possible by means of the said door, to close the interior of the household appliance in relation to the surroundings of the household appliance and wherein the said handle of the door comprises at least a part of an electronic system for cooperation of the household appliance with its user, **characterised in that** it comprises a capacitive coupler (11), which comprises a first electrode (10), which is electrically insulated from any electrically conductive material and arranged in the area above the door aperture, which can be closed by means of the door (4), and a second electrode (12), which is arranged on the side of the said door (4) and spaced from the said first electrode (10), with the said electrodes (10, 12) being electrically insulated from each other, wherein arranged inside the housing (2), in the area above the door aperture, which can be closed by means of the door (4),, is an electronic module (7), comprising an electric circuit (8) and a controller (9) with integrated software that facilitates capacity measurements, which makes it possible to sense the touch of a user (6), and wherein the said handle (5) by means of which it is possible to handle the door (4), is provided as an interface for sensing the touch of the user (6).

2. The household appliance according to claim 1, **characterised in that** the said capacitive coupler (11) allows for an indirect measurement of capacity below the handle (5) of the door (4) and the electric potential of the earth in such a way that the first electrode (10)is galvanically isolated from the handle (5), while the second electrode (12) is, by means of a conductor (13), galvanically connected to the handle (5), which the user can touch (6).

3. The household appliance according to claims 1 and 2, **characterised in that** the said first electrode (10) is formed in such a way that it allows for the compensation of mechanical deviations and structural strain in the manufacture, assembly, and use of the household appliance (1).

4. The household appliance according to any of the preceding claims, **characterised in that** the said second electrode (12) is arranged on the upper rear side of the door (4) in such a way that it is aligned with the opposite first electrode (10) when the door (4) is closed, wherein the second electrode (12) is electrically connected to the handle (5) of the door (4), and simultaneously, by means of an insulating element (14), electrically insulated from any other electrically conductive part of the household appliance (1).

5. The household appliance according to claim 3, **characterised in that** the said first electrode (10) is formed from a flexible material in the manner of a spring.

6. The household appliance according to any of the preceding claims, **characterised in that** the said handle (5) of the door (4) is at least partly made of an electrically conductive material.

7. The household appliance according to any of the preceding claims, **characterised in that** the said handle (5) is electrically insulated from other electrically conductive elements of the door (4) and the housing (2).
